# EUROPEAN PATENT APPLICATION

(11) **EP 2 587 183 A1**
(43) Date of publication of application: **01.05.2013**
(21) Application number: 11187110.9
(22) Date of filing: 28.10.2011
(51) Int. Cl.: F24J 2/10, F24J 2/12, H01L 31/052

(54) **Solar concentrator**

(71) Applicant: Sunrise S.r.l., 20124 Milan (IT)
(72) Inventor: Chiesa, Antonio, 25133 Brescia (IT)
(74) Representative: Lunati & Mazzoni S.r.L.

(57) **Abstract**

It is provided a solar concentrator (1) comprising a base layer (2), a surface layer (3), an adhesive layer (4) connecting said surface layer (3) to said base layer (2), and wherein the surface layer (3) is of glass material and has a thickness less than 2 mm, and the adhesive layer (4) is of bicomponent epoxy resin.

## Description

The present invention relates to a solar concentrator of the type pointed out in the preamble of the first claim.

Solar concentrators are presently known. They substantially consist of parabolas made up of mirrors adapted to receive the rays from the sun and reflect them at a receiving element such as a particular semiconductor or a heatable fluid.

Solar concentrators therefore concentrate the sun rays directed to a wide area of the earth surface on a narrow and restricted point, in particular on a spherical or tubular element.

They enable photovoltaic solar plants to be obtained, i.e. solar plants adapted to convert the radiation from the sun directly into electric energy, with a reduced cost. In fact, most of the cost of photovoltaic plants, not only economic but also in terms of energy, is due to purchase and production of the semiconductive materials forming the photovoltaic cells converting the solar radiation into energy. Consequently, while in classic photovoltaic solar plants the whole surface of the plant is required to be covered with photovoltaic cells, in solar-concentration plants the whole surface is only covered with mirrors, of quite lower cost than the photovoltaic cells, and it is sufficient to dispose the photovoltaic cells exclusively on a very reduced surface.

In addition, solar concentrators enable thermal solar plants to be made, i.e. solar plants adapted to convert the radiation from the sun into heat, which are adapted to generate high-temperature fluids. In fact, while in classic thermal solar plants the temperature is limited by the amount of radiation from the sun striking on the surface of the heat exchanger, in solar concentrators the radiation striking on a wide area can be conveyed towards a very reduced area. The known art mentioned above has some important drawbacks.

In fact, the reflection of the sun rays is not fully efficient because solar concentrators absorb part of the energy radiated from the sun and do not fully reflect the incident radiation. This involves a more reduced yield of the solar-concentration plants and overheating problems connected with same.

In addition, many known solar concentrators are brittle and very expensive. Under this situation, the technical task underlying the present invention is to conceive a solar concentrator capable of substantially obviating the mentioned drawbacks.

Within the scope of this technical task, it is an important aim of the invention to obtain a solar concentrator having high efficiency.

Another important aim of the invention is to manufacture a sturdy solar concentrator.

A further aim of the invention is to conceive a cheap solar concentrator.

The technical task mentioned and the aims specified are achieved by a solar concentrator as claimed in the appended independent claims.

Preferred embodiments are highlighted in the sub-claims.

The features and advantages of the invention are hereinafter clarified by the detailed description of a preferred embodiment/preferred embodiments of the invention, with reference to the accompanying drawings, in which:

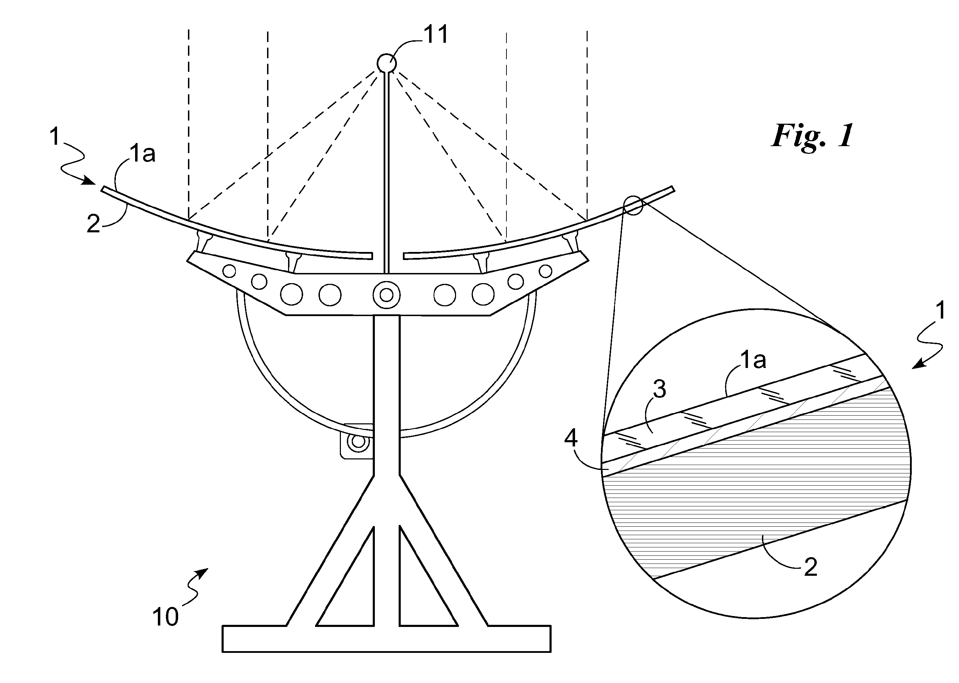

**Fig. 1** shows a section of a solar plant comprising a solar concentrator according to the invention and an enlargement of same.

With reference to the mentioned drawings, the solar concentrator according to the invention is generally denoted at **1**.

It is preferably part of a solar concentration plant **10,** of thermal, photovoltaic, hybrid type or the like. Plant 10, in addition to concentrator 1, also comprises a receiver **11,** known by itself and consisting of an arrangement of tubes including water, an assembly of photovoltaic cells or the like.

The solar concentrator 1 comprises a mirror or reflective surface **1a** adapted to reflect the solar rays and direct them towards the receiver 11.

In addition it has a linear or two-dimensional parabola-shaped conformation. The solar concentrator 1 from a structural point of view is made up of a base layer **2** and a surface layer **3** defining the mirror surface 1a and an adhesive layer **4** connecting the surface layer 3 to the base layer 2.

The surface layer 3 is of glass material and preferably consists of glass of the classic type, i.e. mostly containing amorphous silicon, suitably of low lead content, also known as lime glass. Furthermore, its thickness is lower than 2 mm and preferably included between 0.4 mm and 1.2 mm, more preferably included between 0.6 mm and 1 mm.

The adhesive layer 4 is preferably of bicomponent epoxy resin consisting of: an epoxy resin from bisphenol A, in percentages included between 40% and 20% of the mass of the adhesive layer 4, and more particularly between 25% and 35%, most particularly between 26% and 28%; butanediol diglycidylether in percentages less than 10% of the mass of the adhesive layer 4, and more particularly included between 2% and 5%; lithium and aluminium silicate in percentages included between 50% and 80% of the mass of the adhesive layer 4, and more particularly between 65% and 75%. This epoxy resin is for example marketed by the firm "IWM Innovative world material" under the trade mark "Becor sx 10FR0".

The hardening agents or catalysts used are preferably cycloaliphatic polyamides and in particular trimethylhexamethylenediamine present in percentages close to 5%-10% of the mass of the adhesive layer 4.

This resin has a thermal expansion coefficient included between 15· 10⁻⁶°C⁻¹ and 25· 10⁻⁶°C⁻¹, more preferably between 18·10⁻⁶°C⁻¹ and 22· 10⁻⁶°C⁻¹, and most preferably equal to 2·10⁻⁵°C⁻¹ at a glass transition temperature Tg close to 80-85°C, which makes concentrator 1 always work under the Tg.

The base layer 2 is suitably of a composite material with a polymeric matrix.

In particular, the polymeric matrix is made of epoxy resin and preferably of the same epoxy resin as that constituting the adhesive layer 4. Consequently, the adhesive layer too has a very low thermal expansion coefficient that is not too different from the thermal expansion coefficient of the surface layer 3 and adhesive layer 4. In fact, as known, it is the matrix of the composite materials that mostly determines the behaviour of them as a result of thermal stresses. The base layer 2 preferably further has a fibrous reinforcement made of carbon fibre, aramidic fibre or glass fibre. Finally its thickness is included between 3 mm and 2 cm.

The invention achieves important advantages. In fact, the surface layer 3 of glass material and more particularly of the mentioned types of material, achieves an optimal reflectivity, close to 99.7%, of the mirror surface 1a.

In addition, the stated thickness of the surface layer 3 enables the layer to be conveniently formed so as to create surfaces that are shaped according to the shape defined by the base layer 2. The parabola defined by the base layer 2 can therefore be coated with a single continuous surface layer 3 and it is not necessary to divide said parabola into many flat portions, as it happens in the devices of the known art.

In addition, a further important advantage consists in that the adhesive layer 4 and possibly also the base layer 2 have a thermal expansion coefficient similar to the thermal expansion coefficient of the surface layer 3. In fact, the surface layer in some cases is very brittle and the stresses and efforts arising from different types of deformation due to the different thermal expansion coefficient can lead to breaking of same.

The invention is susceptible of variations falling within the scope of the inventive idea as claimed in the appended independent claims. All of the details can be replaced by equivalent elements and the materials, shapes and sizes can be of any nature and magnitude.

## Claims

1. A solar concentrator (1) comprising a base layer (2), a surface layer (3), an adhesive layer (4) connecting said surface layer (3) to said base layer (2), **characterised in that** said surface layer (3) is of glass material and has a thickness less than 2 mm, and **in that** said adhesive layer (4) comprises bicomponent epoxy resin.

2. A solar concentrator (1) as claimed in claim 1, wherein said base layer (2) is of a composite material having a polymeric matrix and wherein said matrix is made up of the same material as that constituting said adhesive layer (4).

3. A solar concentrator (1) as claimed in one or more of the preceding claims, wherein the thermal expansion coefficient of said adhesive layer (4) is included between 15· 10⁻⁶°C⁻¹ and 25· 10⁻⁶°C⁻¹

4. A solar concentrator (1) as claimed in claim 3, wherein the thermal expansion coefficient of said adhesive layer (4), is included between 18· 10⁻⁶°C⁻¹ and 22·10⁻⁶°C⁻¹.

5. A solar concentrator (1) as claimed in one or more of the preceding claims, wherein said bicomponent epoxy resin is in percentages included between 40% and 20% of the mass of said adhesive layer (4).

6. A solar concentrator (1) as claimed in claim 5, wherein said two-component epoxy resin is in percentages included between 25% and 35% of the mass of said adhesive layer (4).

7. A solar concentrator (1) as claimed in one or more of the preceding claims, wherein said adhesive layer (4) comprises lithium and aluminium silicate in percentages included between 50% and 80% of the mass of said adhesive layer (4).

8. A solar concentrator (1) as claimed in claim 7, wherein said lithium and aluminium silicate is in percentages included between 65% and 75% of the mass of said adhesive layer (4).

9. A solar concentrator (1) as claimed in one or more of the preceding claims, wherein said adhesive layer (4) comprises butanediol diglycidylether in percentages less than 10% of the mass of the adhesive layer (4).

10. A solar concentrator (1) as in claim 9, wherein said butanediol diglycidylether is in percentages less than 2% and 5% of the mass of the adhesive layer (4).

11. A solar concentrator (1) as claimed in one or more of the preceding claims, wherein said surface layer (3) has a thickness included between 0.4 mm and 1.2 mm.

12. A solar concentrator (1) as claimed in claim 7, wherein said surface layer (3) has a thickness included between 0.6 mm and 1 mm.
